# EUROPEAN PATENT APPLICATION

(11) **EP 4 166 869 A1**
(43) Date of publication of application: **19.04.2023**
(21) Application number: 21827078.3
(22) Date of filing: 07.06.2021
(51) Int. Cl.: F25B 21/02

(54) **SEMICONDUCTOR REFRIGERATION PLATE AND MANUFACTURING METHOD THEREFOR**

(30) Priority: 16.06.2020 CN 202010548662
(71) Applicant: BYD Company Limited, Shenzhen, Guangdong 518118 (CN)
(72) Inventor: LI, Yonghui, Shenzhen, Guangdong 518118 (CN); LI, Junqiao, Shenzhen, Guangdong 518118 (CN); ZHOU, Wei, Shenzhen, Guangdong 518118 (CN)
(74) Representative: Gulde & Partner
(86) International application number: PCT/CN2021/098668
(87) International publication number: WO 2021/254203

(57) **Abstract**

A semiconductor refrigeration chip and a method for manufacturing same are provided. The method includes: providing a semiconductor refrigeration assembly, where the semiconductor refrigeration assembly includes a first insulating and heat-conducting layer and a second insulating and heat-conducting layer provided opposite to each other and a semiconductor layer arranged between the first insulating and heat-conducting layer and the second insulating and heat-conducting layer, a side of the semiconductor refrigeration assembly provided with the first insulating and heat-conducting layer is a cold end, and a side of the semiconductor refrigeration assembly provided with the second insulating and heat-conducting layer is a hot end; and forming a packaging structure, and causing the packaging structure to cover a side wall of the semiconductor refrigeration assembly and define a first groove with the first insulating and heat-conducting layer, to obtain the semiconductor refrigeration chip.

## Description

### FIELD

The present disclosure relates to the field of refrigeration device technologies, and specifically to a semiconductor refrigeration chip and a method for manufacturing same.

### BACKGROUND

Semiconductor refrigeration chips are a novel type of refrigerators that achieve the purpose of refrigeration through the Peltier effect. When a direct current passes through a thermocouple formed by two different semiconductor materials connected in series, the two ends of the thermocouple can absorb heat and release heat respectively to realize refrigeration. The semiconductor refrigeration chips have the functions of refrigeration, cooling, temperature maintaining, etc., and can realize point-by-point temperature control, and have the advantages of small size, no mechanical transmission parts, no noise, efficient heat and cold conversion, high reliability, long service life, no environmental pollution, miniaturization, microminiaturization and reciprocal refrigeration and heating and the like.

However, existing semiconductor refrigeration chips and manufacturing methods therefor still needs to be improved.

### SUMMARY

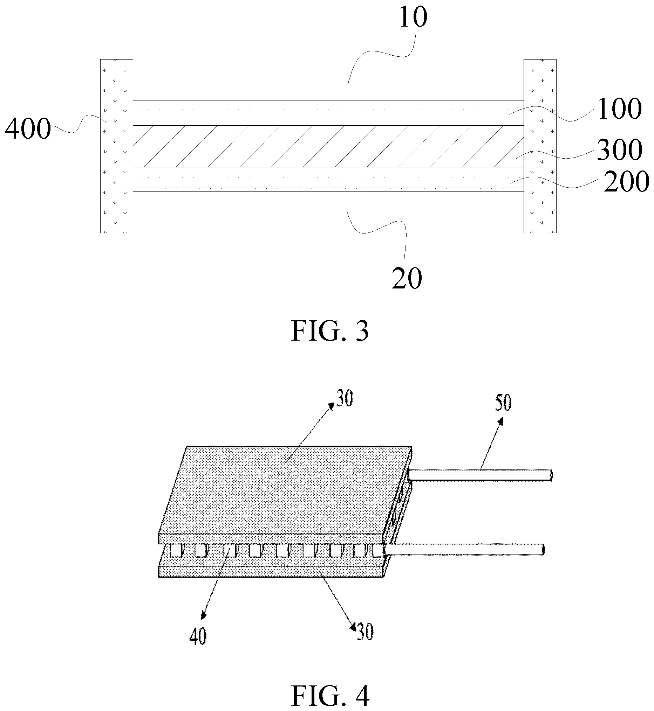

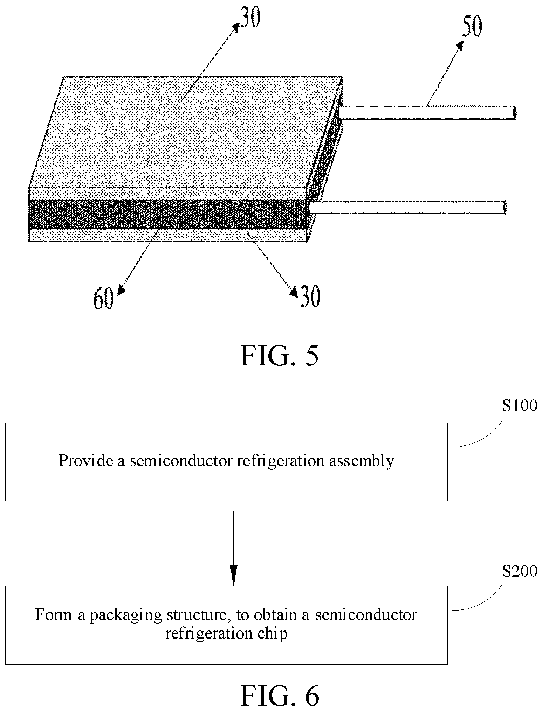

The present disclosure is accomplished based on the discovery and understanding of the following facts and problems by the inventor:
The inventor has found that the existing semiconductor refrigeration chips have the problem of poor overload resistance. Specifically, an existing semiconductor refrigeration chip is generally composed of two ceramic sheets 30 and semiconductor dies 40 sandwiched between the two ceramic sheets 30 (referring to FIG. 4), and mostly the periphery of the semiconductor refrigeration chip is sealed and protected using 703 or 704 white silicone rubber 60 (referring to FIG. 5). During the actual assembly and use of the semiconductor refrigeration chip, to effectively exert the refrigeration effect, the semiconductor refrigeration chip needs to be fixed on the radiator with screws and fixtures. Because the ceramic sheets and the semiconductor dies are brittle and fragile, a slightly uneven force during assembly will cause the ceramic sheets and the semiconductor dies to break, resulting in product failure and affecting the product yield and the refrigeration effect.

The present disclosure aims to alleviating or solving at least one of the above-mentioned problems at least to some extent.

According to one aspect of the present disclosure, a method for manufacturing a semiconductor refrigeration chip is provided. The method includes: providing a semiconductor refrigeration assembly, where the semiconductor refrigeration assembly includes a first insulating and heat-conducting layer and a second insulating and heat-conducting layer provided opposite to each other and a semiconductor layer arranged between the first insulating and heat-conducting layer and the second insulating and heat-conducting layer, a side of the semiconductor refrigeration assembly provided with the first insulating and heat-conducting layer is a cold end, and a side of the semiconductor refrigeration assembly provided with the second insulating and heat-conducting layer is a hot end; and forming a packaging structure, so that the packaging structure covers a side wall of the semiconductor refrigeration assembly and defines a first groove with the first insulating and heat-conducting layer, to obtain the semiconductor refrigeration chip. Therefore, the overload resistance of the semiconductor refrigeration chip can be effectively improved by a simple method, so that the semiconductor refrigeration chip can withstand a pressure of 1000 PSI or more, and the risk of the semiconductor refrigeration chip being broken during the assembly process can be significantly reduced, allowing the semiconductor refrigeration chip to have a high product yield and a good refrigeration effect.

According to one aspect of the present disclosure, a method for manufacturing a semiconductor refrigeration chip is provided. The method includes: providing a semiconductor refrigeration assembly, where the semiconductor refrigeration assembly includes a first insulating and heat-conducting layer and a second insulating and heat-conducting layer provided opposite to each other and a semiconductor layer located between the first insulating and heat-conducting layer and the second insulating and heat-conducting layer, the semiconductor layer includes a plurality of thermocouples, the plurality of thermocouples are connected in series, the plurality of thermocouples are electrically connected to a wire, a side of the semiconductor refrigeration assembly provided with the first insulating and heat-conducting layer is a cold end, and a side of the semiconductor refrigeration assembly provided with the second insulating and heat-conducting layer is a hot end; and forming a packaging structure, so that the packaging structure covers a side wall of the semiconductor refrigeration assembly and defines a first groove with the first insulating and heat-conducting layer, and causing the wire to penetrate through the packaging structure and extend to outside of the packaging structure, to obtain the semiconductor refrigeration chip. Therefore, the overload resistance of the semiconductor refrigeration chip can be effectively improved by a simple method, so that the semiconductor refrigeration chip can withstand a pressure of 1000 PSI or more, and the risk of the semiconductor refrigeration chip being broken during the assembly process can be significantly reduced, allowing the semiconductor refrigeration chip to have a high product yield and a good refrigeration effect.

According to another aspect of the present disclosure, a semiconductor refrigeration chip is provided. The semiconductor refrigeration chip includes: a semiconductor refrigeration assembly, where the semiconductor refrigeration assembly includes a first insulating and heat-conducting layer and a second insulating and heat-conducting layer provided opposite to each other and a semiconductor layer arranged between the first insulating and heat-conducting layer and the second insulating and heat-conducting layer, a side of the semiconductor refrigeration assembly provided with the first insulating and heat-conducting layer is a cold end, and a side of the semiconductor refrigeration assembly provided with the second insulating and heat-conducting layer is a hot end; and a packaging structure, where the packaging structure covers a side wall of the semiconductor refrigeration assembly and defines a first groove with the first insulating and heat-conducting layer. Therefore, the packaging structure can realize the sealing protection of the semiconductor refrigeration assembly, and effectively improve the overload resistance of the semiconductor refrigeration chip, so that the semiconductor refrigeration chip can withstand a pressure of 1000 PSI or more, and the risk of the semiconductor refrigeration chip being broken during the assembly process can be significantly reduced, allowing the semiconductor refrigeration chip to have a high product yield and a good refrigeration effect.

According to another aspect of the present disclosure, a semiconductor refrigeration chip is provided. The semiconductor refrigeration chip includes: a semiconductor refrigeration assembly, where the semiconductor refrigeration assembly includes a first insulating and heat-conducting layer and a second insulating and heat-conducting layer provided opposite to each other and a semiconductor layer arranged between the first insulating and heat-conducting layer and the second insulating and heat-conducting layer, the semiconductor layer includes a plurality of thermocouples, the plurality of thermocouples are connected in series, the plurality of thermocouples are electrically connected to a wire, a side of the semiconductor refrigeration assembly provided with the first insulating and heat-conducting layer is a cold end, and a side of the semiconductor refrigeration assembly provided with the second insulating and heat-conducting layer is a hot end; and a packaging structure, where the packaging structure covers a side wall of the semiconductor refrigeration assembly and defines a first groove with the first insulating and heat-conducting layer, and the wire penetrates through the packaging structure and extends to outside of the packaging structure. Therefore, the packaging structure can realize the sealing protection of the semiconductor refrigeration assembly, and effectively improve the overload resistance of the semiconductor refrigeration chip, so that the semiconductor refrigeration chip can withstand a pressure of 1000 PSI or more, and the risk of the semiconductor refrigeration chip being broken during the assembly process can be significantly reduced, allowing the semiconductor refrigeration chip to have a high product yield and a good refrigeration effect.

### BRIEF DESCRIPTION OF THE DRAWINGS

The foregoing and/or additional aspects and advantages of the present disclosure will become apparent and comprehensible from the following descriptions of the embodiments with reference to the accompanying drawings, where:
FIG. 1 is a schematic structural diagram of a semiconductor refrigeration chip according to an embodiment of the present disclosure.
FIG. 2 is a schematic cross-sectional diagram of a semiconductor refrigeration chip according to an embodiment of the present disclosure.
FIG. 3 is a schematic cross-sectional diagram of a semiconductor refrigeration chip according to another embodiment of the present disclosure.
FIG. 4 is a partial schematic structural diagram of a conventional semiconductor refrigeration chip.
FIG. 5 is a schematic structural diagram of a conventional semiconductor refrigeration chip.
FIG. 6 is a schematic flowchart of a method for manufacturing a semiconductor refrigeration chip according to an embodiment of the present disclosure.
FIG. 7 is a schematic cross-sectional diagram of a semiconductor refrigeration chip according to an embodiment of the present disclosure.
FIG. 8 is a schematic cross-sectional diagram of a semiconductor refrigeration chip according to another embodiment of the present disclosure.

In the drawings:
100: first insulating and heat-conducting layer; 200: second insulating and heat-conducting layer; 300: semiconductor layer; 400: packaging structure; 10: first groove; 20: second groove; 30: ceramic sheet; 40: semiconductor die; 50: wire; 60: silicone rubber.

### DETAILED DESCRIPTION

Embodiments of the present disclosure are described in detail below, and examples of the embodiments are shown in the accompanying drawings. In the accompanying drawings, the same or similar elements and elements having same or similar functions are denoted by same or similar reference numerals throughout. The embodiments described below with reference to the accompanying drawings are exemplary and used merely for explaining the present disclosure, and should not be construed as a limitation on the present disclosure.

According to one aspect of the present disclosure, a method for manufacturing a semiconductor refrigeration chip is provided. According to an embodiment of the present disclosure, referring to FIG. 6, the method includes the following steps.

S 100: Providing a semiconductor refrigeration assembly.

According to an embodiment of the present disclosure, in this step, a semiconductor refrigeration assembly is provided. According to an embodiment of the present disclosure, the semiconductor refrigeration assembly includes a first insulating and heat-conducting layer and a second insulating and heat-conducting layer provided opposite to each other and a semiconductor layer arranged between the first insulating and heat-conducting layer and the second insulating and heat-conducting layer, a side of the semiconductor refrigeration assembly provided with the first insulating and heat-conducting layer is a cold end, and a side of the semiconductor refrigeration assembly provided with the second insulating and heat-conducting layer is a hot end.

Further, the semiconductor layer includes a plurality of thermocouples, the plurality of thermocouples are connected in series, and the plurality of thermocouples are electrically connected to a wire. When in use, a direct current may be applied to the semiconductor refrigeration assembly through the wire. Those skilled in the art can understand that the plurality of thermocouples of the semiconductor layer may be connected in series through copper sheets sintered inside the insulating and heat-conducting layer. The wire is connected to the outermost copper sheet (i.e., the copper sheet closest to an edge of the insulating and heat-conducting layer), to achieve the electrical connection between the thermocouples and the wire. The serial connection between the thermocouples and the electrical connection between the thermocouples and the wire may be achieved by the same connection methods as those in a conventional semiconductor refrigeration chip.

According to an embodiment of the present disclosure, in this step, a semiconductor refrigeration assembly is provided. According to an embodiment of the present disclosure, the semiconductor refrigeration assembly includes a first insulating and heat-conducting layer and a second insulating and heat-conducting layer provided opposite to each other and a semiconductor layer arranged between the first insulating and heat-conducting layer and the second insulating and heat-conducting layer, the semiconductor layer includes a plurality of thermocouples, the plurality of thermocouples are connected in series, a side of the semiconductor refrigeration assembly provided with the first insulating and heat-conducting layer is a cold end, and a side of the semiconductor refrigeration assembly provided with the second insulating and heat-conducting layer is a hot end. In addition, the plurality of thermocouples are electrically connected to a wire. When in use, a direct current may be applied to the semiconductor refrigeration assembly through the wire. Those skilled in the art can understand that the plurality of thermocouples of the semiconductor layer may be connected in series through copper sheets sintered inside the insulating and heat-conducting layer. The wire is connected to the outermost copper sheet (i.e., the copper sheet closest to an edge of the insulating and heat-conducting layer), to realize the electrical connection between the thermocouples and the wire. The serial connection between the thermocouples and the electrical connection between the thermocouples and the wire may be achieved by the same connection methods as those in a conventional semiconductor refrigeration chip.

The manufacturing process of the semiconductor refrigeration assembly is not particularly limited, and may be designed by those skilled in the art according to a commonly used manufacturing process for semiconductor refrigeration chips, which will not be described in detail herein.

The specific constituent materials of the first insulating and heat-conducting layer and the second insulating and heat-conducting layer are not particularly limited. For example, the first insulating and heat-conducting layer and the second insulating and heat-conducting layer may independently include at least one of a ceramic sheet, a glass sheet, an aluminum nitride sheet, or an aluminum sheet with an oxide film.

S200: Forming a packaging structure to obtain a semiconductor refrigeration chip.

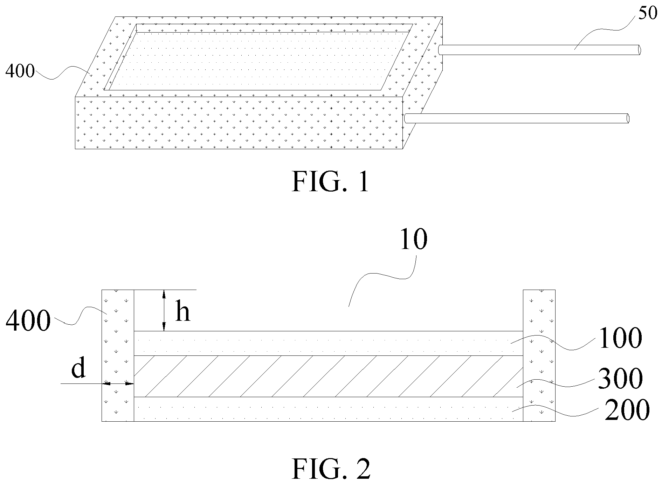

According to an embodiment of the present disclosure, in this step, a packaging structure is formed to obtain a semiconductor refrigeration chip (referring to FIG. 1). According to an embodiment of the present disclosure, the packaging structure formed is caused to cover a side wall of the semiconductor refrigeration assembly and define a first groove with the first insulating and heat-conducting layer. To be specific, the packaging structure and a cold end side of the semiconductor refrigeration assembly define the first groove. Therefore, during assembly, the part of the packaging structure higher than the first insulating and heat-conducting layer is in contact with the fixture, and the pressure of the fixture is mainly exerted on the packaging structure, not on the semiconductor refrigeration assembly. Whereby, the overload resistance of the semiconductor refrigeration chip can be effectively improved, and the risk of the semiconductor refrigeration chip being broken can be significantly reduced, allowing the semiconductor refrigeration chip to have a high product yield and a good refrigeration effect. Because the packaging structure and the first insulating and heat-conducting layer define the first groove, that is, the first insulating and heat-conducting layer is at least partially exposed to the outside, the refrigeration effect of the semiconductor refrigeration chip can be ensured.

Further, the wire is caused to penetrate through the packaging structure and extend to outside of the packaging structure (referring to FIG. 1, that is, the wire electrically connected to the thermocouples penetrates through the packaging structure and is exposed to the outside of the packaging structure, for an external control circuit to apply a direct current to the semiconductor refrigeration chip through the wire).

According to an embodiment of the present disclosure, in this step, a packaging structure is formed to obtain a semiconductor refrigeration chip (referring to FIG. 1). According to an embodiment of the present disclosure, the packaging structure is caused to cover a side wall of the semiconductor refrigeration assembly and define a first groove with the first insulating and heat-conducting layer. To be specific, the packaging structure anda cold end side of the semiconductor refrigeration assembly define the first groove. In addition, the wire is caused to penetrate through the packaging structure and extend to outside of the packaging structure (referring to FIG. 1, that is, the wire electrically connected to the thermocouples penetrates through the packaging structure and is exposed to the outside of the packaging structure, for an external control circuit to apply a direct current to the semiconductor refrigeration chip through the wire). Therefore, during assembly, the part of the packaging structure higher than the first insulating and heat-conducting layer is in contact with the fixture, and the pressure of the fixture is mainly exerted on the packaging structure, not on the semiconductor refrigeration assembly. Whereby, the overload resistance of the semiconductor refrigeration chip can be effectively improved, and the risk of the semiconductor refrigeration chip being broken can be significantly reduced, allowing the semiconductor refrigeration chip to have a high product yield and a good refrigeration effect. Because the packaging structure and the first insulating and heat-conducting layer define the first groove, that is, the first insulating and heat-conducting layer is at least partially exposed to the outside, the refrigeration effect of the semiconductor refrigeration chip can be ensured.

According to an embodiment of the present disclosure, the packaging structure may be formed by injection molding, cooling and solidification. Specifically, first, the semiconductor refrigeration assembly is placed in a mold. Then, a material for forming the packaging structure is heated to a molten state, the temperature and pressure for injection molding are adjusted, and the melted material is injected into the mold followed by cooling and solidification, so as to form the packaging structure.

According to an embodiment of the present disclosure, a material for forming the packaging structure includes at least one of a polyamide hot melt adhesive, a polyolefin hot melt adhesive, or a reactive polyurethane hot melt adhesive. The material has the advantages of insulation, temperature resistance, impact resistance, vibration reduction, moisture-proof, waterproof, dust-proof, chemical corrosion resistance, etc. The material has a wide temperature range (-40°C-150°C), low-temperature flexibility, and high-temperature creep resistance, and can firmly bond the first insulating and heat-conducting layer and the second insulating and heat-conducting layer, so that the formed packaging structure has excellent performances, making the semiconductor refrigeration chip suitable for various harsh production environments and usage environment. In addition, the material may be injection molded under low temperature and low pressure conditions. The solidification time is short, the process is simple, and the production cycle can be significantly shortened. Also, the packaging structure formed by injection molding is relatively hard and not easily damaged, which improves the protection of the semiconductor refrigeration assembly. Further, the material is suitable for packaging of an electronic product (i.e. the semiconductor refrigeration assembly described above) without causing internal damage to the electronic product.

In addition, the inventor has found that the complete solidification time of silicone rubber, such as 703 or 704 white silicone rubber, in a conventional method of sealing the semiconductor refrigeration chip, is at least 12 hours, which leads to a long production cycle of the product, and the silicone rubber is soft and easily damaged and provides poor protection for semiconductor dies. The packaging structure proposed in the present disclosure has low-temperature flexibility and high-temperature creep resistance, the material can be injection molded under low temperature and low pressure conditions, the solidification time is short, and the process is simple.

According to an embodiment of the present disclosure, the mold used in the injection molding process has a cavity of a predetermined shape. After the semiconductor refrigeration assembly is placed in the cavity of the mold, the semiconductor refrigeration assembly occupies a part of the cavity, and the packaging material is injected into the remaining part of the cavity to form the packaging structure. The shape of the part of the cavity for injecting the packaging material matches with the shape of the packaging structure, so as to obtain the packaging structure that covers the side wall of the semiconductor refrigeration assembly and define the first groove with the first insulating and heat-conducting layer.

According to an embodiment of the present disclosure, the shape and size of the cavity may further be adjusted, to cause the packaging structure to define a groove (i.e., a second groove) with the second insulating and heat-conducting layer. Thereby, the overload resistance of the semiconductor refrigeration chip can be further improved.

According to an embodiment of the present disclosure, the mold used in the injection molding process may be an aluminum mold. On the one hand, the cost of the aluminum mold is lower. On the other hand, the packaging material described above has less adhesion to the aluminum mold than to a steel mold and therefore can be more easily demolded.

According to an embodiment of the present disclosure, the pressure during the injection molding may be 2-40 bar, e.g., 2 bar, 5 bar, 8 bar, 10 bar, 12 bar, 15 bar, 18 bar, 20 bar, 22 bar, 25 bar, 28 bar, 30 bar, 32 bar, 35 bar, 38 bar, or 40 bar, and the temperature during injection molding may be 150-240°C, e.g., 150°C, 160°C, 170°C, 180°C, 190°C, 200°C, 210°C, 220°C, 230°C, or 240°C. Therefore, the packaging material can be kept in a molten state during the injection molding, and the packaging material can keep good performance.

According to an embodiment of the present disclosure, a time of the cooling and solidification may be 10-50s. Therefore, the production cycle can be significantly shortened.

According to an embodiment of the present disclosure, referring to FIG. 2, a wall thickness (defined as d as shown in the figure) of the packaging structure 400 formed may be 0.2-1 mm, e.g., 0.2 mm, 0.3 mm, 0.4 mm, 0.5 mm, 0.6 mm, 0.7 mm, 0.8 mm, 0.9 mm, or 1 mm. The inventor has found that a too large wall thickness of the packaging structure (for example, greater than 1 mm) reduces the refrigeration effect of the semiconductor refrigeration chip, and a too small wall thickness of the packaging structure (for example, less than 0.2 mm) is not conducive to significantly improving the overload resistance of the semiconductor refrigeration chip. In the present disclosure, setting the wall thickness of the packaging structure to be within the above range can significantly improve the overload resistance of the semiconductor refrigeration chip and enable the semiconductor refrigeration chip to have a good refrigeration effect.

According to an embodiment of the present disclosure, referring to FIG. 2, the packaging structure 400 only defines the first groove 10 with the first insulating and heat-conducting layer 100, and a depth of the first groove 10 (defined as h as shown in the figure) satisfies 0<h≤1 mm. Preferably, the depth of the first groove is 0.2-1 mm, e.g., 0.2 mm, 0.3 mm, 0.4 mm, 0.5 mm, 0.6 mm, 0.7 mm, 0.8 mm, 0.9 mm, or 1 mm. Therefore, the overload resistance of the semiconductor refrigeration chip can be significantly improved, the semiconductor refrigeration chip is enabled to have a good refrigeration effect, and the first groove has a suitable depth, which facilitates the formation of the first groove in the process of fabricating the packaging structure. The inventor has found that a too large depth of the first groove (for example, greater than 1 mm) indicates a too large distance between the semiconductor refrigeration chip and the fixture, which reduces the refrigeration effect of the semiconductor refrigeration chip. Therefore, setting the depth of the first groove to be not exceeding 1 mm not only can improve the overload resistance of the semiconductor refrigeration chip, but also can ensure that the semiconductor refrigeration chip has a good refrigeration effect.

According to an embodiment of the present disclosure, referring to FIG. 3, the packaging structure 400 defines the first groove 10 with the first insulating and heat-conducting layer 100, and at the same time, the packaging structure 400 defines the second groove 20 with the second insulating and heat-conducting layer 200. The depths of the first groove 10 and the second groove 20 may be, respectively and independently, 0.2-1 mm,. Therefore, the overload resistance of the semiconductor refrigeration chip can be further improved. In addition, there is a suitable distance between the cold end side of the semiconductor refrigeration assembly and the fixture, and there is a suitable distance between the hot end side of the semiconductor refrigeration assembly and the radiator, which can enable the semiconductor refrigeration chip to have a good refrigeration effect.

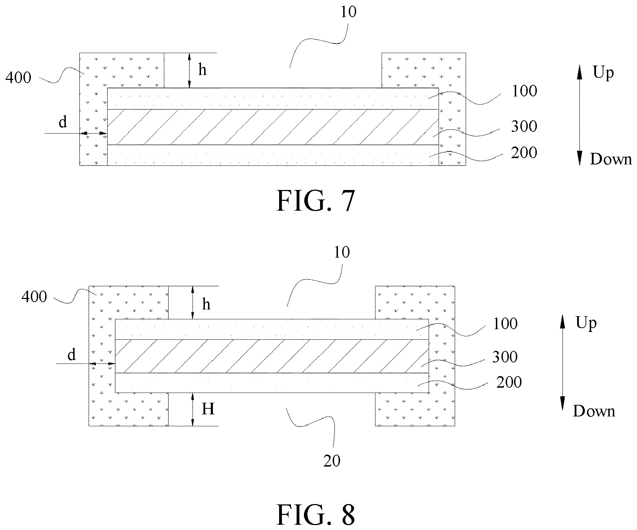

An area of an opening of each of the first groove and the second groove is not particularly limited. For example, the area of the opening of the first groove 10 is smaller than an area of the first insulating and heat-conducting layer 100 (referring to FIG. 7), or the area of the opening of the first groove 10 is consistent with the area of the first insulating and heat-conducting layer 100 (referring to FIG. 1 and FIG. 2). The area of the opening of the second groove 20 is smaller than an area of an opening of the second insulating and heat-conducting layer 200 (referring to FIG. 8), or the area of the opening of the second groove 20 is consistent with the area of the opening of the second insulating and heat-conducting layer 200 (referring to FIG. 3). Preferably, the area of the opening of the first groove is consistent with the area of the first insulating and heat-conducting layer, and the area of the opening of the second groove is consistent with the area of the second insulating and heat-conducting layer. Therefore, the overload resistance of the semiconductor refrigeration chip can be improved, and the semiconductor refrigeration chip is enabled to have a good refrigeration effect.

Based on the above, the overload resistance of the semiconductor refrigeration chip can be effectively improved by a simple method, so that the semiconductor refrigeration chip can withstand a pressure of 1000 PSI or more, and the risk of the semiconductor refrigeration chip being broken during the assembly process can be significantly reduced, allowing the semiconductor refrigeration chip to have a high product yield and a good refrigeration effect.

According to one aspect of the present disclosure, a semiconductor refrigeration chip is provided. According to an embodiment of the present disclosure, the semiconductor refrigeration chip may be manufactured by the method described above. Therefore, the semiconductor refrigeration chip has the same features and advantages as the semiconductor refrigeration chip manufactured by the method described above, and the details will not be repeated herein.

According to an embodiment of the present disclosure, referring to FIG. 1 and FIG. 2, the semiconductor refrigeration chip includes: a semiconductor refrigeration assembly and a packaging structure 400. The semiconductor refrigeration assembly includes a first insulating and heat-conducting layer 100 and a second insulating and heat-conducting layer 200 provided opposite to each other and a semiconductor layer 300 (referring to FIG. 2) arranged between the first insulating and heat-conducting layer 100 and the second insulating and heat-conducting layer 200. The semiconductor layer 300 includes a plurality of thermocouples (not shown in the figure). The plurality of thermocouples are connected in series. The plurality of thermocouples are electrically connected to a wire 50. A side of the semiconductor refrigeration assembly provided with the first insulating and heat-conducting layer 100 is a cold end, and a side of the semiconductor refrigeration assembly provided with the second insulating and heat-conducting layer 200 is a hot end. The packaging structure 400 covers a side wall of the semiconductor refrigeration assembly and defines a first groove 10 with the first insulating and heat-conducting layer 100. The wire 50 penetrates through the packaging structure 400 and extends to outside of the packaging structure 400. (referring to FIG. 1, that is, the wire electrically connected to the thermocouples penetrates through the packaging structure and is exposed to the outside of the packaging structure, for an external control circuit to apply a direct current to the semiconductor refrigeration chip through the wire). Therefore, the packaging structure can realize the sealing protection of the semiconductor refrigeration assembly, and effectively improve the overload resistance of the semiconductor refrigeration chip, so that the semiconductor refrigeration chip can withstand a pressure of 1000 PSI or more, and the risk of the semiconductor refrigeration chip being broken during the assembly process can be significantly reduced, allowing the semiconductor refrigeration chip to have a high product yield and a good refrigeration effect.

According to an embodiment of the present disclosure, the packaging structure 400 covers a side wall of the semiconductor refrigeration assembly, which can realize the sealing protection of the semiconductor refrigeration assembly. The packaging structure 400 defines the first groove 10 with the first insulating and heat-conducting layer 100. Specifically, the part of the packaging structure 400 covering the semiconductor refrigeration assembly extends toward the side with the first insulating and heat-conducting layer 100, and the part of the packaging structure 400 higher than the first insulating and heat-conducting layer 100 defines the first groove 10 with the first insulating and heat-conducting layer 100 (referring to FIG. 1 and FIG. 2). To be specific, the packaging structure and a cold end side of the semiconductor refrigeration assembly define the first groove. Since the cold end of the semiconductor refrigeration chip is the main force-bearing end during assembly, the packaging structure and the cold end side of the semiconductor refrigeration assembly are caused to define the first groove. During assembly, the fixture is in contact with the part of the packaging structure higher than the first insulating and heat-conducting layer, and the pressure of the fixture is mainly exerted on the packaging structure, not on the semiconductor refrigeration assembly. Whereby, the overload resistance of the semiconductor refrigeration chip can be effectively improved, and the risk of the semiconductor refrigeration chip being broken during the assembly process can be significantly reduced, allowing the semiconductor refrigeration chip to have a high product yield and a good refrigeration effect. Because the packaging structure and the first insulating and heat-conducting layer define the first groove, that is, the first insulating and heat-conducting layer is at least partially exposed to the outside, the refrigeration effect of the semiconductor refrigeration chip can be ensured.

According to an embodiment of the present disclosure, the semiconductor refrigeration chip can withstand a pressure of 1000 PSI or above. A conventional semiconductor refrigeration chip will be damaged under a pressure of more than 500 PSI. Therefore, the pressure that the semiconductor refrigeration chip of the present disclosure can withstand is significantly higher than that a conventional semiconductor refrigeration chip can withstand, and can well protect the insulating and heat-conducting layers and the inner semiconductor layer even in the case of a too large pressure or an uneven force, thereby significantly reducing the risk of breakage of the semiconductor refrigeration chip during assembly, and improving the usage yield and the refrigeration effect of the semiconductor refrigeration chip.

According to an embodiment of the present disclosure, referring to FIG. 3, on the basis that the packaging structure 400 defines the first groove 10 with the first insulating and heat-conducting layer 100, the packaging structure 400 further defines the second groove 20 with the second insulating and heat-conducting layer 200. Specifically, the part of the packaging structure 400 covering the semiconductor refrigeration assembly extends toward the side with the second insulating and heat-conducting layer 200, and the part of the packaging structure 400 higher than the second insulating and heat-conducting layer 200 defines the second groove 20 with the second insulating and heat-conducting layer 200. That is to say, the packaging structure further defines the second groove with a hot end side of the semiconductor refrigeration assembly. Therefore, during assembly, the part of the packaging structure higher than the first insulating and heat-conducting layer is in contact with the fixture, and the part of the packaging structure higher than the second insulating and heat-conducting layer is in contact with the radiator, thus can further improve the overload resistance of the semiconductor refrigeration chip.

According to an embodiment of the present disclosure, referring to FIG. 2, a wall thickness (defined as d as shown in the figure) of the packaging structure 400 may be 0.2-1 mm. Therefore, the overload resistance of the semiconductor refrigeration chip can be significantly improved, and the semiconductor refrigeration chip is enabled to have a good refrigeration effect.

According to an embodiment of the present disclosure, referring to FIG. 2, the packaging structure 400 only defines the first groove 10 with the first insulating and heat-conducting layer 100, and a depth of the first groove 10 (defined as h as shown in the figure) satisfies 0<h≤1 mm. Preferably, the depth of the first groove is 0.2-1 mm. Therefore, the overload resistance of the semiconductor refrigeration chip can be significantly improved, the semiconductor refrigeration chip is enabled to have a good refrigeration effect, and the first groove has a suitable depth, and the formation of the first groove is facilitated in the process of fabricating the packaging structure. The inventor has found that a too large depth of the first groove (for example, greater than 1 mm) indicates a too large distance between the semiconductor refrigeration chip and the fixture, which reduces the refrigeration effect of the semiconductor refrigeration chip. Therefore, setting the depth of the first groove to be not exceeding 1 mm not only can improve the overload resistance of the semiconductor refrigeration chip, but also can ensure that the semiconductor refrigeration chip has a good refrigeration effect. It should be noted that the depth h of the first groove may or may not be equal to the wall thickness d (referring to FIG. 2) of the packaging structure, which may be designed by those skilled in the art according to actual situations.

According to an embodiment of the present disclosure, referring to FIG. 3, the packaging structure 400 and the first insulating and heat-conducting layer 100 define the first groove 10, and at the same time, the packaging structure 400 and the second insulating and heat-conducting layer 200 define the second groove 20. The depths of the first groove 10 and the second groove 20 may be, respectively and independently, 0.2-1 mm. Therefore, the overload resistance of the semiconductor refrigeration chip can be further improved. In addition, there is a suitable distance between the cold end side of the semiconductor refrigeration assembly and the fixture, and there is a suitable distance between the hot end side of the semiconductor refrigeration assembly and the radiator, which can enable the semiconductor refrigeration chip to have a good refrigeration effect. It should be noted that the depth H of the second groove (as shown in FIG. 8) may or may not be equal to the depth h of the first groove, and the depth of the second groove may or may not be equal to the wall thickness d of the packaging structure, which may be designed by those skilled in the art according to actual situations.

Shapes of openings of the first groove and the second groove are not particularly limited, and may be designed by those skilled in the art according to actual situations. For example, according to an embodiment of the present disclosure, the shapes of the openings of the first groove 10 and the second groove 20 may respectively and independently include at least one of a quadrangle, a circle, or an ellipse.

The areas of the openings of the first groove and the second groove are also not particularly limited. For example, the area of the opening of the first groove 10 is smaller than an area of the first insulating and heat-conducting layer 100 (referring to FIG. 7), or the area of the opening of the first groove 10 is consistent with the area of the first insulating and heat-conducting layer 100 (referring to FIG. 1 and FIG. 2). The area of the opening of the second groove 20 is smaller than an area of an opening of the second insulating and heat-conducting layer 200 (referring to FIG. 8), or the area of the opening of the second groove 20 is consistent with the area of the opening of the second insulating and heat-conducting layer 200 (referring to FIG. 3). Preferably, the area of the opening of the first groove is consistent with the area of the first insulating and heat-conducting layer, and the area of the opening of the second groove is consistent with the area of the second insulating and heat-conducting layer. Therefore, the overload resistance of the semiconductor refrigeration chip can be improved, and the semiconductor refrigeration chip is enabled to have a good refrigeration effect.

It should be noted that when the area of the opening of the first groove 10 is smaller than the area of the first insulating and heat-conducting layer 100, that is, the packaging structure 400 covers a part of an upper surface of the first insulating and heat-conducting layer 100 ("up" as shown in FIG. 7), the thickness of the part of the packaging structure 400 covering the upper surface of the first insulating and heat-conducting layer 100 is the depth h of the first groove 10. The thickness h of this part may or may not be equal to the thickness d of the part of the packaging structure 400 covering the side wall of the semiconductor refrigeration assembly (referring to FIG. 7). Similarly, when the area of the opening of the second groove 20 is smaller than the area of the second insulating and heat-conducting layer 200, that is, the packaging structure 400 covers a part of a lower surface of the second insulating and heat-conducting layer 200 ("down" as shown in FIG. 8), the thickness of the part of the packaging structure 400 covering the lower surface of the second insulating and heat-conducting layer 200 is the depth H of the second groove 20. The thickness H of this part may or may not be equal to the thickness d of the part of the packaging structure 400 covering the side wall of the semiconductor refrigeration assembly (referring to FIG. 8).

According to an embodiment of the present disclosure, the packaging structure defines grooves with the insulating and heat-conducting layers, which can also improve the consistency of the assembly thickness of the product at the application end. It is well known to those skilled in the art that during assembly, it is necessary to coat the cold end and the hot end of the semiconductor refrigeration chip with a thermally conductive silicone to ensure the thermal conductivity of the product, and the thermally conductive silicone is mostly manually coated, an uneven thickness is likely to be obtained during coating a conventional semiconductor refrigeration chip with a thermally conductive silicone, affecting the thermal conductivity. Since the semiconductor refrigeration chip of the present disclosure is provided with grooves of a certain depth, and coating the thermally conductive silicone requires only filling the grooves with the thermally conductive silicone, the coating efficiency and the thermal conductivity of the product are effectively improved.

The specific material for forming the packaging structure is not particularly limited, as long as the material can protect the semiconductor refrigeration assembly and can be easily molded to form the structure described above. For example, according to an embodiment of the present disclosure, a material for forming the packaging structure 400 may include at least one of a polyamide hot melt adhesive, a polyolefin hot melt adhesive, or a reactive polyurethane hot melt adhesive. The material has the advantages of insulation, temperature resistance, impact resistance, vibration reduction, moisture-proof, waterproof, dust-proof, chemical corrosion resistance, etc. The material has a wide temperature range (-40°C-150°C), low-temperature flexibility, and high-temperature creep resistance, and can firmly bond the first insulating and heat-conducting layer and the second insulating and heat-conducting layer, so that the formed packaging structure has excellent performance, making the semiconductor refrigeration chip suitable for various harsh production environments and usage environment. Further, the material is suitable for packaging of an electronic product (i.e. the semiconductor refrigeration assembly described above) without causing internal damage to the electronic product.

According to an embodiment of the present disclosure, the packaging structure 400 may be formed by injection molding, cooling and solidification. The material for forming the packaging structure may be injection molded under low temperature and low pressure conditions. The solidification time is short (10-50s), the process is simple, and the production cycle can be significantly shortened. Also, the packaging structure formed by injection molding is relatively hard and not easily damaged, which improves the protection of the semiconductor refrigeration assembly.

The specific constituent materials of the first insulating and heat-conducting layer and the second insulating and heat-conducting layer are not particularly limited. For example, the first insulating and heat-conducting layer 100 and the second insulating and heat-conducting layer 200 may independently include at least one of a ceramic sheet, a glass sheet, an aluminum nitride sheet, or an aluminum sheet with an oxide film.

According to an embodiment of the present disclosure, the semiconductor layer 300 includes a plurality of thermocouples. Each of the plurality of thermocouples includes a P-type semiconductor die and an N-type semiconductor die. The plurality of thermocouples are connected in series. When a direct current is applied to the thermocouples, the semiconductor refrigeration chip can achieve the refrigeration effect. The arrangement of the semiconductor dies and the way of the serial connection of the thermocouples are not particularly limited, and may be designed by those skilled in the art according to conventional semiconductor refrigeration chips, which will not be described in detail herein.

The solutions of the present disclosure will be described below through specific examples. It should be noted that the following examples are only used to illustrate the present disclosure, and should not be construed as limiting the scope of the present disclosure. The embodiments in which specific technologies or conditions are not indicated shall be carried out in accordance with the technologies or conditions described in the literature in the art or in accordance with the product specification.

### Example 1

The semiconductor refrigeration chip includes a semiconductor refrigeration assembly and a packaging structure. The semiconductor refrigeration assembly includes a first insulating and heat-conducting layer and a second insulating and heat-conducting layer provided opposite to each other and a semiconductor layer arranged between the first insulating and heat-conducting layer and the second insulating and heat-conducting layer. A side of the semiconductor refrigeration assembly provided with the first insulating and heat-conducting layer is a cold end, and a side of the semiconductor refrigeration assembly provided with the second insulating and heat-conducting layer is a hot end. The packaging structure covers a side wall of the semiconductor refrigeration assembly, defines a first groove with the first insulating and heat-conducting layer, and defines a second groove with the second insulating and heat-conducting layer.

The first insulating and heat-conducting layer and the second insulating and heat-conducting layer are both ceramic sheets. An area of an opening of the first groove is consistent with an area of the first insulating and heat-conducting layer. An area of an opening of the second groove is consistent with an area of the second insulating and heat-conducting layer.

The packaging structure is formed of a polyamide hot melt adhesive. The wall thickness of the packaging structure is 0.2 mm. The depths of the first groove and the second groove are both 0.2 mm.

The manufacturing process of the semiconductor refrigeration chip was as follows.
(1) The semiconductor refrigeration assembly was placed in an aluminum mold.
(2) The molten polyamide hot melt adhesive was injected into the aluminum mold, where the temperature during the injection molding was 150°C, and the pressure during the injection molding was 2 bar.
(3) After the injection molding was completed, the heating was stopped, followed by natural cooling and solidification, where the solidification time was 10s.
(4) The mold was opened, and the packaged semiconductor refrigeration chip was taken out.

### Example 2

The structure and manufacturing process of the semiconductor refrigeration chip in this example are basically the same as those in Example 1, except that: the wall thickness of the packaging structure was 0.8 mm, the depths of the first groove and the second groove were both 0.6 mm, the temperature during the injection molding was 240°C, the pressure during the injection molding was 40 bar, and the solidification time was 50s.

### Example 3

The structure and manufacturing process of the semiconductor refrigeration chip in this example are basically the same as those in Example 1, except that: the wall thickness of the packaging structure was 1 mm, and the depths of the first groove and the second groove were both 1 mm.

### Example 4

The structure and manufacturing process of the semiconductor refrigeration chip in this example are basically the same as those in Example 1, except that: the packaging structure only defined a first groove with the first insulating and heat-conducting layer, and the depth of the first groove was 0.2 mm.

### Example 5

The structure and manufacturing process of the semiconductor refrigeration chip in this example are basically the same as those in Example 4, except that: the depth of the first groove was 0.1 mm.

### Example 6

The structure and manufacturing process of the semiconductor refrigeration chip in this example are basically the same as those in Example 1, except that: the packaging structure was formed of a polyolefin hot melt adhesive, and the temperature during the injection molding was 180°C.

### Example 7

The structure and manufacturing process of the semiconductor refrigeration chip in this example are basically the same as those in Example 1, except that: the packaging structure was formed of a reactive polyurethane hot melt adhesive, and the temperature during the injection molding was 180°C.

### Comparative Example 1

The semiconductor refrigeration chip includes a semiconductor refrigeration assembly and a sealant. The semiconductor refrigeration assembly includes a first insulating and heat-conducting layer and a second insulating and heat-conducting layer provided opposite to each other and a semiconductor layer arranged between the first insulating and heat-conducting layer and the second insulating and heat-conducting layer. A side of the semiconductor refrigeration assembly provided with the first insulating and heat-conducting layer is a cold end, and a side of the semiconductor refrigeration assembly provided with the second insulating and heat-conducting layer is a hot end. The sealant was 704 white silicone rubber arranged around a periphery of the semiconductor refrigeration assembly.

### Performance test

1. Overload resistance tests were respectively carried out on the semiconductor refrigeration chips of Examples 1-7 and Comparative Example 1. Specifically, 10 samples were selected from each example respectively (for example, 10 samples from Example 1, 10 samples from Example 2, 10 samples from Example 3, 10 samples from Example 4, 10 samples from Example 5, 10 samples from Example 6, and 10 samples from Example 7). 10 samples were selected from Comparative Example 1. The samples were respectively tested for overload resistance. The test results are shown in Table 1. Test standard: SJ-T 1013 5-2010.

The "maximum pressure value that can withstand " of the samples of each of the examples and the comparative example is the average value of the maximum pressures that the 10 samples can withstand in the example or comparative example.

The semiconductor refrigeration assemblies in Examples 1-7 and Comparative Example 1 were refrigeration assemblies of the same model.

2. 10 prepared samples were further selected from each of the examples and the comparative example. A pressure of 500 PSI was applied to the samples, and the usage yield of each of the examples and the comparative example was calculated. The test results are shown in Table 1.

3. The refrigeration capacities of the semiconductor refrigeration chips of Examples 1-7 and Comparative Example 1 were tested respectively. The current applied during the test was 3 A. The test results are shown in Table 1.

**Table 1**

| | Maximum pressure that can withstand (PSI) | Usage yield under a pressure of 500 PSI | Refrigeration capacity (W) |
|---|---|---|---|
| Example 1 | 1200 | 100% | 17.7 |
| Example 2 | 1350 | 100% | 16.0 |
| Example 3 | 1500 | 100% | 15.3 |
| Example 4 | 1160 | 100% | 17.0 |
| Example 5 | 1135 | 100% | 17.4 |
| Example 6 | 1220 | 100% | 17.7 |
| Example 7 | 1228 | 100% | 17.5 |
| Comparative Example 1 | 260 | 40% | 17.7 |

It should be noted that the " maximum pressure that can withstand " refers to a critical pressure at which cracks are formed in the semiconductor refrigeration chip. "Usage yield under a pressure of 500 PSI" refers to the percentage of the number of samples having no cracks formed under the pressure of 500 PSI among 10 samples in the total number of samples.

It can be seen from Table 1 that, compared with conventional semiconductor refrigeration chips (i.e., Comparative Example 1), the overload resistance of the semiconductor refrigeration chip of the present disclosure (i.e., Examples 1-7) is significantly improved, and the maximum pressure that can withstand is 1000 PSI or above, the product usage yield is significantly improved, and a good refrigeration effect is achieved.

Compared with the semiconductor refrigeration chip where the packaging structure only defines a groove with the cold end side of the semiconductor refrigeration assembly, the semiconductor refrigeration chip where the packaging structure defines grooves respectively with the cold end side and the hot end side of the semiconductor refrigeration assembly has a higher overload resistance (as indicated by a comparison between Examples 1-3 and Example 4).

In the description of the present disclosure, orientation or position relationships indicated by the terms such as "up" and "down" are based on orientation or position relationships shown in the accompanying drawings, and are used for ease of description only, rather than requiring the present disclosure to be constructed and operated in a particular orientation. Therefore, such terms should not be construed as limiting of the present disclosure.

In the description of this specification, the description with reference to the terms "one embodiment", "another embodiment", and the like means that the specific feature, structure, material, or characteristic described in conjunction with the embodiment is included in at least one embodiment of the present disclosure. In this specification, exemplary description of the foregoing terms does not necessarily refer to a same embodiment or example. Besides, the specific features, the structures, the materials, or the characteristics that are described may be combined in proper manners in any one or more embodiments or examples. In addition, a person skilled in the art may integrate or combine different embodiments or examples described in this specification and features of the different embodiments or examples provided that they are not contradictory to each other. It is also to be noted that in this specification, the terms "first" and "second" are merely used for descriptive purposes but are not to be construed as indicating or implying relative importance or implicitly specifying the number of technical features indicated.

Although the embodiments of the present disclosure have been shown and described above, it can be understood that the foregoing embodiments are exemplary and should not be understood as a limitation on the present disclosure. Those of ordinary skill in the art may make changes, modifications, replacements, and variations to the foregoing embodiments without departing from the scope of the present disclosure.

## Claims

1. A method for manufacturing a semiconductor refrigeration chip, comprising:
providing a semiconductor refrigeration assembly, wherein the semiconductor refrigeration assembly comprises a first insulating and heat-conducting layer and a second insulating and heat-conducting layer provided opposite to each other and a semiconductor layer arranged between the first insulating and heat-conducting layer and the second insulating and heat-conducting layer, a side of the semiconductor refrigeration assembly provided with the first insulating and heat-conducting layer is a cold end, and a side of the semiconductor refrigeration assembly provided with the second insulating and heat-conducting layer is a hot end; and
forming a packaging structure, so that the packaging structure covers a side wall of the semiconductor refrigeration assembly and defines a first groove with the first insulating and heat-conducting layer, to obtain the semiconductor refrigeration chip.

2. The method according to claim 1, wherein the semiconductor layer comprises a plurality of thermocouples, the plurality of thermocouples are connected in series, and the plurality of thermocouples are electrically connected to a wire; and
the wire is caused to penetrate through the packaging structure and extend to outside of the packaging structure.

3. The method according to claim 1 or 2, further comprising:
causing the packaging structure and the second insulating and heat-conducting layer to define a second groove.

4. The method according to any one of claims 1-3, wherein the packaging structure is formed by injection molding, cooling and solidification.

5. The method according to claim 4, wherein a pressure during the injection molding is 2-40 bar, and a temperature during the injection molding is 150-240°C.

6. The method according to claim 4 or 5, wherein a time of the cooling and solidification is 10-50s.

7. The method according to any one of claims 1-6, wherein a wall thickness of the packaging structure formed is 0.2-1 mm.

8. The method according to claim 1, wherein a depth of the first groove is 0.2-1 mm.

9. The method according to claim 3, wherein depths of the first groove and the second groove are, respectively and independently, 0.2-1 mm.

10. A semiconductor refrigeration chip, comprising:
a semiconductor refrigeration assembly, wherein the semiconductor refrigeration assembly comprises a first insulating and heat-conducting layer and a second insulating and heat-conducting layer provided opposite to each other and a semiconductor layer arranged between the first insulating and heat-conducting layer and the second insulating and heat-conducting layer, a side of the semiconductor refrigeration assembly provided with the first insulating and heat-conducting layer is a cold end, and a side of the semiconductor refrigeration assembly provided with the second insulating and heat-conducting layer is a hot end; and
a packaging structure, wherein the packaging structure covers a side wall of the semiconductor refrigeration assembly and defines a first groove with the first insulating and heat-conducting layer.

11. The semiconductor refrigeration chip according to claim 10, wherein the semiconductor layer comprises a plurality of thermocouples, the plurality of thermocouples are connected in series, and the plurality of thermocouples are electrically connected to a wire.

12. The semiconductor refrigeration chip according to claim 10, wherein the wire penetrates through the packaging structure and extends to outside of the packaging structure.

13. The semiconductor refrigeration chip according to any one of claims 10-12, wherein the packaging structure and the second insulating and heat-conducting layer define a second groove.

14. The semiconductor refrigeration chip according to any one of claims 10-13, wherein a wall thickness of the packaging structure is 0.2-1 mm.

15. The semiconductor refrigeration chip according to any one of claims 10-14, wherein a depth of the first groove is 0.2-1 mm.

16. The semiconductor refrigeration chip according to claim 13, wherein depths of the first groove and the second groove are, respectively and independently, 0.2-1 mm.

17. The semiconductor refrigeration chip according to any one of claims 10-16, wherein a shape of an opening of the groove comprises at least one of a quadrangle, a circle, or an ellipse.

18. The semiconductor refrigeration chip according to claim 10, wherein an area of an opening of the first groove is consistent with an area of the first insulating and heat-conducting layer.

19. The semiconductor refrigeration chip according to claim 13, wherein an area of an opening of the second groove is consistent with an area of the second insulating and heat-conducting layer.

20. The semiconductor refrigeration chip according to any one of claims 10-19, wherein a material for forming the packaging structure comprises at least one of a polyamide hot melt adhesive, a polyolefin hot melt adhesive, or a reactive polyurethane hot melt adhesive.

21. The semiconductor refrigeration chip according to claim 10, wherein the first insulating and heat-conducting layer and the second insulating and heat-conducting layer respectively and independently comprise at least one of a ceramic sheet, a glass sheet, an aluminum nitride sheet, or an aluminum sheet with an oxide film.
